# EUROPEAN PATENT APPLICATION

(11) **EP 1 469 512 A1**
(43) Date of publication of application: **20.10.2004**
(21) Application number: 02767901.8
(22) Date of filing: 05.09.2002
(51) Int. Cl.: H01L 21/60

(54) **MODULE DEVICE**

(30) Priority: 23.01.2002 JP 2002014355
(71) Applicant: Fujitsu Media Devices Limited, Yokohama-shi, Kanagawa 222-0033 (JP)
(72) Inventor: MIYAJI, Naomi, c/o FUJITSU MEDIA DEVICES LIMITED, Yokohama-shi, Kanagawa 222-0033 (JP); KUROKAWA, Junko, FUJITSU MEDIA DEVICES LIMITED, Yokohama-shi, Kanagawa 222-0033 (JP)
(74) Representative: Stebbing, Timothy Charles
(86) International application number: PCT/JP2002/009038
(87) International publication number: WO 2003/063232

(57) **Abstract**

A module device with mounted components with no damage in reliability. This device has a board with metallized connection electrodes and components mounted on the board by arrangement in the longitudinal direction of the board, and each connected to the connection electrode via a bump. Bumps for connecting the components to the board connection electrodes are so set that their height may increase toward the side of the board with the reference of the height of the bump located at the center region in the longitudinal direction of the board.

## Description

### FIELD OF THE INVENTION

The present invention relates to a module component on which a component such as a surface acoustic wave element is mounted and sealed.

### BACKGROUND OF THE INVENTION

As electronic devices have been miniaturized in recent years, small and thin electronic components are required to be mounted on such electronic devices, particularly cellular phones. In the mean time, for easy manufacturing and miniaturization, there has been employed a module component having a plurality of chip components mounted on a package.

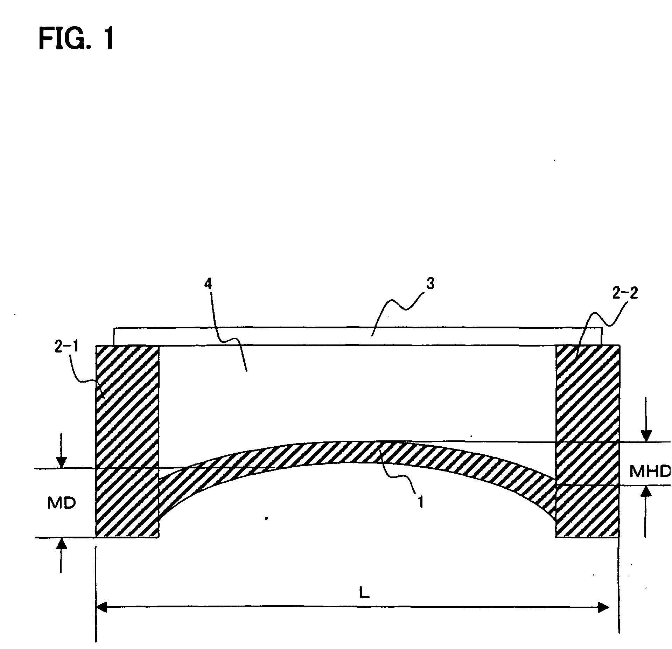

FIG. 1 shows a cross sectional view of a module component package. The package has a chip carrier constituted of a chip carrier substrate 1 and chip carrier surrounding walls (packagechips) 2-1, 2-2, in which a plurality of electronic components are housed. Further, a plurality of chip components are housed in a package space 4 and sealed with a cap 3.

The chip carrier is formed by burning an alumina layer on which electrodes are metalized on substrate 1. At this time, assuming an exemplary package width L is on the order of 3 mm, a warp MD having a maximum size of 0.030 mm is produced on substrate 1 after the burning. This results in producing a height difference MHD of 0.010 mm to 0.025 mm on the chip carrier substrate 1.

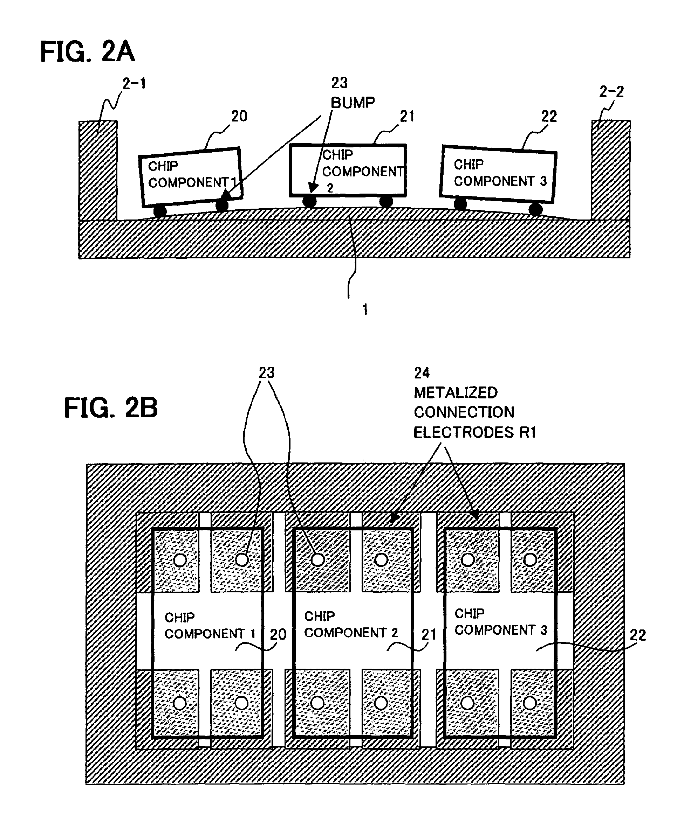

As a result, the plurality of chip components mounted on the chip carrier produce such a state as shown in FIG. 2. FIG. 2A shows a cross sectional view of the chip carrier with cap 3 removed. FIG. 2B shows a top plan view of the chip carrier, in which three chip components 20 - 22 are orderly mounted on substrate 1.

Each chip component 20 - 22 is electrically connected to metalized connection electrodes 24 via bumps 23. At this time, as shown in FIG. 2A, it is difficult to place the plurality of chip components horizontally, because of the warp MD of substrate 1. This brings about difficulty in the manufacturing process. Also, when manufacturing a module component in which chip components are laminated, as disclosed in the official gazette of Japanese Unexamined Patent Publication No. 2000-151346, the non-uniformity in the height direction affects the characteristics of the mounted chip component. As a result, the overall characteristics of the package component are affected, and the reliability is damaged.

### DISCLOSURE OF THE INVENTION

Accordingly, it is an object of the present invention to provide a module component having a plurality of components mounted thereon, without damaging the reliability of the module component.

Also, it is an object of the present invention to provide a module component having a greater number of components mounted thereon, by laminating a plurality of components.

As a first aspect of the module component according to the present invention to attain the aforementioned object, the module component includes; a substrate having connection electrodes metalized thereon; and a plurality of components orderly mounted on the substrate in the longitudinal direction of the substrate, and electrically connected to the connection electrodes via bumps. The heights of the bumps connecting the plurality of components to the connection electrodes of the substrate are set to be larger in the direction toward the edge of the substrate, being referenced from the height of the bump positioned in the center area of the substrate in the longitudinal direction of the substrate.

As a second aspect of the module component according to the present invention to attain the aforementioned object, the module component includes; a substrate having connection electrodes metalized thereon; and a component mounted on the substrate and electrically connected to the connection electrodes via bumps. The component is connected to the connection electrodes with at least three bumps in the longitudinal direction of the substrate, and the heights of the plurality of bumps are set to be larger in the direction toward the edge of the substrate, being referenced from the height of the bump positioned in the center area.

As a third aspect of the module component according to the present invention to attain the aforementioned object, the module component includes; a substrate having connection electrodes metalized thereon; and a plurality of components orderly mounted on the substrate in the longitudinal direction of the substrate, and electrically connected to the connection electrodes via bumps. The heights of the connection electrodes to which the plurality of components are connected via the bumps are set to be larger in the direction toward the edge of the substrate, being referenced from the height of the connection electrode corresponding to the bump positioned in the center area of the substrate.

As a fourth aspect of the module component according to the present invention to attain the aforementioned object, the module component includes; a substrate having connection electrodes metalized thereon; and a component mounted on the substrate, and electrically connected to the connection electrodes via bumps. The component is connected to the connection electrodes with at least three bumps in the longitudinal direction of the substrate, and the heights of the respective connection electrodes corresponding to the plurality of bumps are set to be larger in the direction toward the edge of the substrate, being referenced from the height of the connection electrode corresponding to the bump positioned in the center area.

As a fifth aspect of the module component according to the present invention to attain the aforementioned object, the module component includes; a first substrate having connection electrodes metalized thereon; a first component mounted on the first substrate and electrically connected to the connection electrodes via bumps; a second substrate of which an area corresponding to the first component is hollowed out, laminated on the first substrate, and having connection electrodes metalized thereon; and a second component mounted on the second substrate above the first components, and electrically connected to the connection electrodes via bumps. Either the first component or the second component is constituted of a plurality of components, and the plurality of components are orderly mounted on the corresponding first or second substrate, and the heights of the connection electrodes to which the plurality of components are connected via the bumps are set to be larger in the direction toward the edge of the first or second substrate, being referenced from the height of the connection electrode corresponding to the bump positioned in the center area of the corresponding first or second substrate in the longitudinal direction.

As a sixth aspect of the module component according to the present invention to attain the aforementioned object, the module component includes; a first substrate having connection electrodes metalized thereon; a first component mounted on the first substrate and electrically connected to the connection electrodes via bumps; a second substrate of which an area corresponding to the first component is hollowed out, laminated on the first substrate, and having connection electrodes metalized thereon; and a second component mounted on the second substrate above the first components, and electrically connected to the connectionelectrodesvia bumps.Eitherthefirstcomponent or the second component is connected to the connection electrodes with at least three bumps in the longitudinal direction of the corresponding first or second substrate, and the heights of the plurality of bumps are set to be larger in the direction toward the edge of the corresponding first or second substrate, being referenced from the height of the bump positioned in the center area.

As a seventh aspect of the module component according to the present invention to attain the aforementioned object, in any one of the first to fourth aspects, the substrate is a ceramic substrate burnt after the electrodes are metalized on an alumina layer.

As an eighth aspect of the module component according to the present invention to attain the aforementioned object, in any one of the first to fourth aspects, the component is a surface acoustic wave element having comb electrodes formed on the face opposite to the substrate on which the element is mounted via the bumps, and the component is sealed with both a package chip formed in the periphery of the substrate and a cap structure.

As a ninth aspect of the module component according to the present invention to attain the aforementioned object, in the third or fourth aspect, the heights of the connection electrodes are set by the number of layers of the connection electrodes.

Further features of the present invention will become more apparent by the following description of the embodiments with the accompanied drawings.

### BRIEF DESCRIPTION OF THE DRAWINGS

FIG. 1 shows a cross sectional view of a module component package.
FIG. 2 shows a condition in which a plurality of chip components are mounted on a chip carrier.
FIG. 3 shows a first embodiment of the present invention.
FIG. 4 shows a second embodiment of the present invention.
FIG. 5 shows a third embodiment of the present invention.
FIG. 6 shows a fourth embodiment of the present invention.

### THE PREFERRED EMBODIMENTS OF THE INVENTION

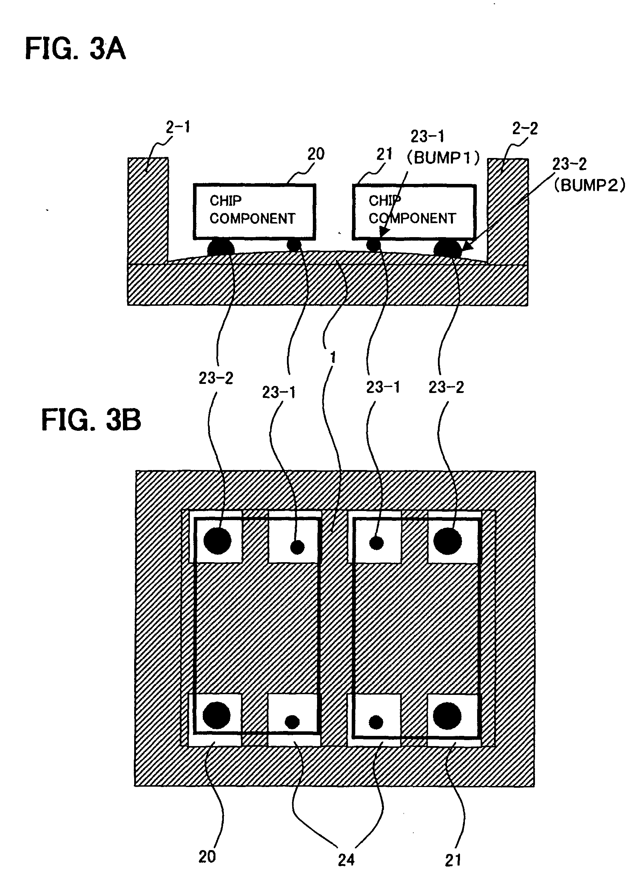

FIG. 3 shows a first embodiment of the present invention. FIG. 3A is a cross sectional view of a chip carrier with a cap 3 removed. FIG. 3B is a top plan view of the chip carrier. Two chip components 20, 21 are mounted on a chip carrier substrate 1.

A feature of this embodiment is that the sizes of bumps 23-1, 23-2 connecting a plurality of chip components 20, 21 to metalized connection electrodes"24 are varied, correspondingly to the warp of the chip carrier substrate 1.

More specifically, in the embodiment shown in FIG. 3, connection electrodes 24 are metalized on substrate 1, and the plurality of chip components (two chip components in the case of FIG. 3) 20, 21 are mounted on connection electrodes 24 via bumps 23-1, 23-2.

Further, the heights of the bumps connecting the plurality of chip components 20, 21 to connection electrodes 24 on substrate 1 are set to be larger in the direction toward the edge of substrate 1 (refer to bumps 23-2), being referenced from the height of bump 23-1 positioned in the center area of the substrate 1 in the longitudinal direction of substrate 1 (i.e. lateral direction in the figure).

Here, the height variations of the bumps set to be larger in the direction toward the edge of substrate 1 are to be given correspondingly to the amount of the warp of substrate 1. Thus, the heights of the bumps are adjusted correspondingly to the warp of substrate 1 of the chip carrier, and chip components 20, 21 can be mounted horizontally. This is to be applied to any embodiments of the present invention described in the following.

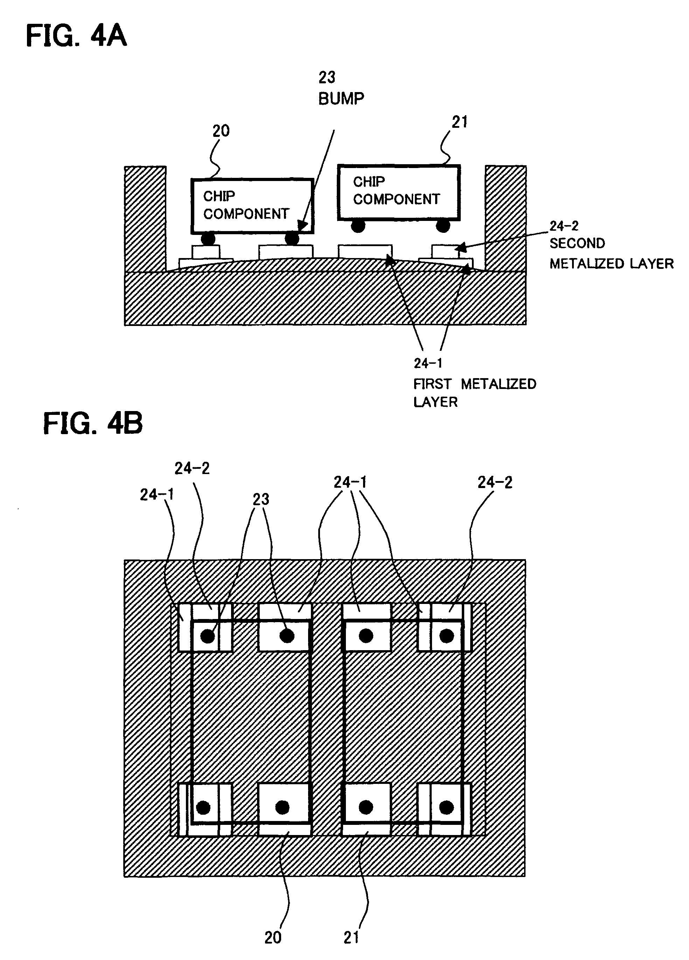

FIG. 4 shows a second embodiment of the present invention. Similarly to the embodiment shown in FIG. 3, FIG. 4A shows a cross-sectional view of the chip carrier with cap 3 removed, and FIG. 4B shows a top plan view of the chip carrier. Two chip components 20, 21 are mounted in a similar way.

The feature of this embodiment is that the sizes of bumps 23 are uniform. In contrast, the heights of the connection electrodes to which the plurality of chip components 20, 21 are connected via bumps 23 are set to be larger in the direction toward the edge of substrate 1, being referenced from the height of connection electrode 24-1 corresponding to bump 23 positioned in the center area of substrate 1.

To obtain the aforementioned structure, according to the embodiment shown in FIG. 4, each metalized layer positioned in the vicinity of the edge of substrate 1 has a two-layer structure constituted of a first metalized layer 24-1 and a second metalized layer 24-2 overlaying the first metalized layer 24-1.

In such a way, the heights of the connection electrodes are set to be larger in the direction toward the edge of substrate 1, being referenced from the height of connection electrode 24-1 corresponding to bump 23 positioned in the center area of the substrate 1.

Here, the heights of the connection electrodes set to be larger against the height of bump 24-1 positioned in the center area in the direction toward the edge of substrate 1, which are obtained by adjusting the numbers of the overlaid connection electrode layers, are to be determined correspondingly to the amount of the warp of substrate 1. Thus, according to the warp of chip carrier substrate 1, the heights of the bumps are adjusted, so that the chip components 20, 21 can be mounted horizontally.

Additionally, in the embodiment shown in FIG. 4, it is also possible to adjust the thickness of each connection electrode using either a single layer or a multi-layer more than two layers, in place of two-layer structure constituted of the first metalized layer 24-1 and 24-2.

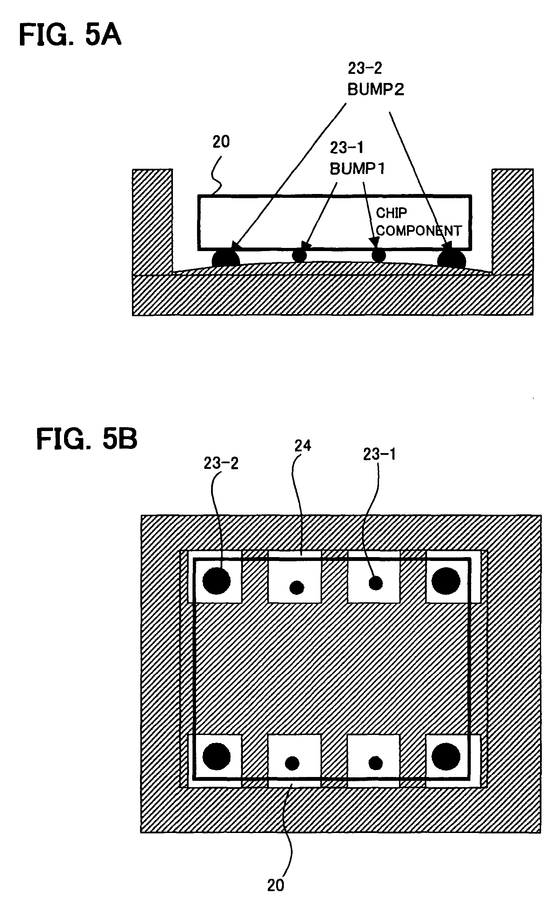

FIG. 5 shows a third embodiment of the present invention. Similarly to the above-mentioned embodiments, FIG. 5A is a cross-sectional view of the chip carrier with cap 3 removed, and FIG. 5B is a top plan view of the chip carrier. However, in this embodiment, a single chip component 20 is mounted.

Furthermore, this chip component 20 is connected to connection electrodes 24 on substrate 1 and mounted thereon via at least more than two bumps (four bumps in the embodiment shown in FIG. 5) '23-1, 23-2 against the longitudinal direction of substrate 1.

In this embodiment, similarly to the embodiment shown in FIG. 3, the heights of bumps 23-2 are set to be larger in the direction toward the edge of substrate 1, being referenced from the height of bump 23-1 positioned in the center area. Thus, it becomes possible to connect the electrodes of chip component 20 correctly to electrodes 24 formed on substrate 1.

Here, when the number of bumps at least more than two in the longitudinal direction of substrate 1 is odd, the height of one bump positioned at the center is determined as the reference. Meanwhile, when the number of bumps is even, the heights of two bumps positioned in the center area are determined as the reference. Additionally, in the embodiment shown in FIG. 5, it is also possible to structure so that the heights of connection electrodes 24 are varied, without varying the heights of the bumps, in a similar way to the embodiment shown in FIG. 4.

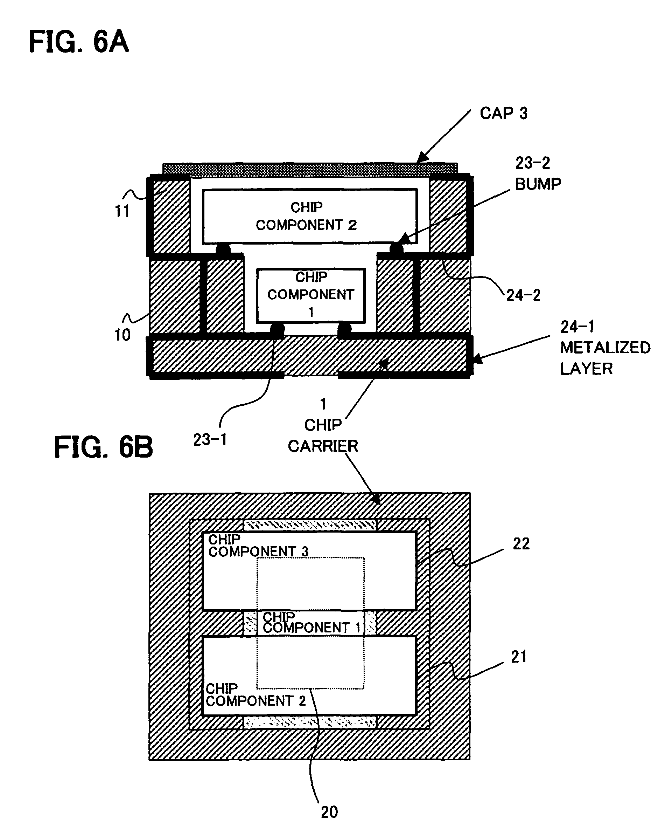

Further, FIG. 6 is a fourth embodiment of the present invention.

FIG. 6A is a cross-sectional view of the package, and FIG. 6B is a top plan view o'f the chip carrier permeating through cap 3. The embodiment shown in FIG. 6 is a structure enablingminiaturization, particularly a smallmount area, of the module having a plurality of chip components mounted thereon, of the module.

In other words, this embodiment illustrates a case of applying the present invention to a component package structure in which chip components are laminated, forming a plurality of layers, similarly to the structure disclosed in the aforementioned official gazette of Japanese Unexamined Patent Publication No. 2000-151346.

A first chip component 20, electrically connected to connection electrodes 24-1 via bumps 23-1, is mounted on a first substrate 1 having connection electrodes 24-1 metalized thereon.

Moreover, an area corresponding to this first chip component 20 is hollowed out, and a second substrate 10 having a metalized connection electrode 24-2 laminated on the first substrate 1 is provided.

In the corresponding positions above the first chip component 20, a plurality of second chip components (two components in the example shown in FIG. 6) 21, 22, which are electrically connected to connection electrodes 24-2 formed on the second substrate 10, are mounted on the second substrate 10.

Here, as a feature of this embodiment, in the first chip component 20 or the second chip components 21, 22, the feature of the present invention described earlier is applied in the relation between bumps 23-1, 23-2 and connection electrodes 24-1, 24-2.

Namely, one chip 20 is mounted on the corresponding first substrate 1. Here, the relation between chip 20 and substrate 1 is similar to the case illustrated in FIG. 5. Chip 20 is connected to connection electrodes 24-1 by at least three bumps 23-1 in the longitudinal direction of substrate 1.

Further, the heights of the plurality of bumps 23-1 are set to be larger in the direction toward the edge of the corresponding first substrate 1, being referenced from the height of the bump positioned in the center area. Here, the variation in the heights of bumps 23-1 is to be given correspondingly to the amount of the warp of substrate 1. Thus, the heights of the bumps are adjusted correspondingly to the warp of chip carrier substrate 1, and the chip component 20 can be mounted horizontally.

In the meantime, in FIG. 6, chips 21, 22 are mounted on the second substrate 10, in the corresponding positions above chip 20. Here, the relation between the second substrate 10 and chips 21, 22 is similar to the case shown in FIG. 3. Chips 21, 22 are connected by the bumps, in which the heights of connection electrodes 24-2 are set to be larger in the direction toward the second substrate or the edge of the second substrate, being referenced from the height of the bump positioned in the center area of the second substrate 10 in the longitudinal direction.

In this case, similarly to the foregoing embodiments, the variation of the heights of the bumps or the variation in the connection electrodes are to be given corresponding to the amount of the warp of substrate 10. Thus, correspondingly to the warp of chip carrier substrate 10, the heights of the bumps are adjusted, and the chip components 21, 22 can be mounted horizontally.

Additionally, with regard to the connection of chips 20, 21, 22 to connection electrodes 24-1, 24-2 via bumps 23-1, 23-2, it is also possible to change the heights of connection electrodes 24-1, 24-2 connecting chips 20, 21, 22, similarly to FIG. 4, without changing the heights of the bumps.

Furthermore, in FIG. 6, a carrier chip 11 is provided on the second substrate 10, and cap 3 is covered over this carrier chip 11. Thus, chip components 20 - 22 are mounted and sealed.

Here, in the embodiment shown in FIG. 6, one chip 20 is mounted on the first substrate 1, and two chips 21, 22 are mounted on the second substrate 10. However, the application of the present invention is not limited to the above embodiment. It may also be possible to reverse the relation described above. Namely, it is possible to structure the module having a plurality of chip components mounted on the first substrate 1, and one chip component mounted on the second substrate 10.

Or, it is possible to mount either one chip component or a plurality of chip components on both the first substrate 1 and the second substrate 10. In this case also, the relation of chip components connected to connection electrodes via bumps is as shown in FIGS. 3 - 5.

In the foregoing description of the embodiments of the present invention, a surface acoustic wave element may be applicable as a chip component. The application of the present invention is not limited to this element. The present invention may be applicable to components for any other purposes.

### INDUSTRIAL APPLICABILITY

As the embodiments of the present invention have been described, according to the present invention, it becomes possible to provide a module component having a plurality of components mounted thereon, and a module component having more components by laminating these components, without damaging the reliability of the module component.

## Claims

1. A module component comprising:
a substrate having connection electrodes metalized thereon; and
a plurality of components orderly mounted on the substrate in the longitudinal direction of the substrate, and electrically connected to the connection electrodes via bumps,
wherein the heights of the bumps connecting the plurality of components to the connection electrodes of the substrate are set to be larger in the direction toward the edge of the substrate, being referenced from the height of the bump positioned in the center area of the substrate in the longitudinal direction of the substrate.

2. A module component comprising:
a substrate having connection electrodes metalized thereon; and
a component mounted on the substrate, and electrically connected to the connection electrodes via bumps,
wherein the component is connected to the connection electrodes with at least three bumps in the longitudinal direction of the substrate, and
the heights of the plurality of bumps are set to be larger in the direction toward the edge of the substrate, being referenced from the height of the bump positioned in the center area.

3. A module component comprising:
a substrate having connection electrodes metalized thereon; and
a plurality of components orderly mounted on the substrate in the longitudinal direction of the substrate, and electrically connected to the connection electrodes via bumps,
wherein the heights of the connection electrodes to which the plurality of components are connected via the bumps are set to be larger in the direction toward the edge of the substrate, being referenced from the height of the connection electrode corresponding to the bump positioned in the center area of the substrate.

4. A module component comprising:
a substrate having connection electrodes metalized thereon; and
a component mounted on the substrate, and electrically connected to the connection electrodes via bumps,
wherein the component is connected to the connection electrodes with at least three bumps in the longitudinal direction of the substrate, and
the heights of the respective connection electrodes corresponding to the plurality of bumps are set to be larger in the direction toward the edge of the substrate, being referenced from the height of the connection electrode corresponding to the bump positioned in the center area.

5. The module component according to any of claim 1 to claim 4,
wherein the substrate is a ceramic substrate burnt after the electrodes are metalized on an alumina layer.

6. The module component according to any of claim 1 to claim 4,
wherein the component is a surface acoustic wave element having comb electrodes formed on the face opposite to the substrate on which the element is mounted via the bumps, and the component is sealed with both a package chip formed in the periphery of the substrate and a cap structure.

7. The module component according to claim 3 or claim 4,
wherein the heights of the connection electrodes are set by the number of layers of the connection electrodes.

8. A module component comprising:
a first substrate having connection electrodes metalized thereon;
a first component mounted on the first substrate, and electrically connected to the connection electrodes via bumps;
a second substrate of which an area corresponding to the first component is hollowed out, laminated on the first substrate, and having connection electrodes metalized thereon; and
a second component mounted on the second substrate above the first components, and electrically connected to the connection electrodes via bumps,
wherein either the first component or the second component is constituted of a plurality of components, and
the plurality of components are orderly mounted on the corresponding first or second substrate, and
the heights of the connection electrodes to which the plurality of components are connected via the bumps are set to be larger in the direction toward the edge of the first or second substrate, being referenced from the height of the connection electrode corresponding to the bump positioned in the center area of the corresponding first or second substrate in the longitudinal direction.

9. A module component comprising:
a first substrate having connection electrodes metalized thereon;
a first component mounted on the first substrate, and electrically connected to the connection electrodes via bumps;
a second substrate of which an area corresponding to the first component is hollowed out, laminated on the first substrate, and having connection electrodes metalized thereon; and
a second component mounted on the second substrate above the first components, and electrically connected to the connection electrodes via bumps,
wherein either the first component or the second component is connected to the connection electrodes with at least three bumps in the longitudinal direction of the corresponding first or second substrate, and the heights of the plurality of bumps are set to be larger in the direction toward the edge of the corresponding first or second substrate, being referenced from the height of the bump positioned in the center area.

10. The module component according to claim 8 or claim 9,
wherein the component is a surface acoustic wave element having comb electrodes formed on the face opposite to the substrate, on which the element is mounted via the bumps, and the component is sealed with both a package chip formed in the periphery of the substrate and a cap structure.

11. The module component according to claim 8 or claim 9,
wherein the substrate is a ceramic substrate burnt after the electrodes are metalized on an alumina layer.

12. The module component according to claim 8,
wherein the heights of the connection electrodes are set by the number of layers of the connection electrodes.
